# EUROPÄISCHE PATENTANMELDUNG

(11) **EP 1 845 613 A1**
(43) Veröffentlichungstag der Anmeldung: **17.10.2007**
(21) Anmeldenummer: 07006895.2
(22) Anmeldetag: 03.04.2007
(51) Int. Cl.: H03D 3/00

(54) **Verfahren und Schaltung zur Trägerregelung in einem Quadraturdemodulator**

(30) Priorität: 13.04.2006 DE 102006017868
(71) Anmelder: Micronas GmbH, 79108 Freiburg i. Br. (DE)
(72) Erfinder: Witte, Franz-Otto, 79331 Teningen (DE)
(74) Vertreter: Göhring, Robert

(57) **Zusammenfassung**

Die Erfindung bezieht sich auf ein Verfahren zur Trägerregelung in einem Quadraturdemodulator, bei dem ein komplexwertiges Eingangssignal (I, Q) einem Mischer (1) zugeführt wird zum Mischen mit einer Mischfrequenz (fm) zu einem Mischsignal (Ir, Qr), das Mischsignal (Ir, Qr) einer Verarbeitungsstrecke (2) zum Erzeugen eines verarbeiteten Signals (Ie, Qe) zugeführt wird, das verarbeitete Signal (Ie, Qe) einer Phasenmesseinrichtung (3) zum Messen einer Phase (ϕm) des verarbeiteten Signals (Ie, Qe) zugeführt wird und die gemessene Phase (ϕm) einer Phasenregelung (4) zugeführt wird zum Regeln der Mischfrequenz (fm), wobei während zumindest der Verarbeitung in der Verarbeitungsstrecke (2) eine Totzeit (z^{-d}) entsteht. Zum Ermöglichen eines schnelleren Einschwingens wird die Mischfrequenz (fm) aufsummiert oder aufintegriert wird zu einer Mischphase (ϕc), die Mischphase (ϕc) sowohl für den Mischvorgang verwendet als auch zur Phasenregelung (4, 23) rückgeführt und ein durch die Rückführung entstehender Fehler durch eine zeitverzögerte zweite Rückführung der Mischphase (ϕc) kompensiert.

## Beschreibung

Die Erfindung bezieht sich auf ein Verfahren und eine Schaltung zur Trägerregelung in einem Quadraturdemodulator gemäß den oberbegrifflichen Merkmalen des Patentanspruchs 1.

Fig. 3 zeigt eine beispielhafte Schaltungsanordnung zur Trägerregelung in einem Quadraturdemodulator. Ein komplexwertiges Eingangssignal I, Q wird einem Mischer 1 zugeführt zum Mischen mit einer Mischfrequenz fm zu einem Mischsignal Ir, Qr. Dieses Mischsignal Ir, Qr wird einer Verarbeitungsstrecke 2 mit einem Kanalentzerrer angelegt, wodurch eine Signalverzögerung um eine sogenannte Totzeit z^{-d} zwischen einem davon verarbeiteten Signal Ie, Qe und dem Mischsignal Ir, Qr entsteht. Das verarbeitete Signal Ie, Qe wird einem Rotator 4 angelegt, der das angelegte Signal rotiert und einer Schaltung zur Phasenmessung 3 zuführt, welche zum Messen einer Phase ϕm des verarbeiteten Signals Ie, Qe ausgebildet ist. Ein Regler 4 bestimmt die Mischfrequenz fm und legt diese einem Mischer 1 an.

Bei einer solchen Anordnung besteht ein generelles Problem, welches bei digitalen Demodulatoren für terrestrische Signale entsteht, welche im Allgemeinen mit Kanalentzerrern ausgestattet werden. Die Gruppenlaufzeit der Kanalentzerrer bildet im Zusammenhang mit den Impulsformungsfiltern für die Träger- und Taktregelung im Wesentlichen eine Totzeit, welche eine solche Regelung prinzipiell langsam macht. Dies bereitet für die Adaption der Kanalentzerrung große Probleme.

Mit Blick auf dieses Problem wird von der bekannten Schaltung in Fig. 3 das komplexwertige verarbeitete Signal Ie, Qe an einen Rotator 5 weitergeleitet, welcher das angelegte Signal rotiert und über eine Stufe zur Phasenmessung 3 einem Entscheider 6 zuführt. Der Entscheider 6 führt in für sich bekannter Art und Weise einen Entscheidungsprozess durch und gibt das entschiedene Signal an einen zweiten Regler 7 und an einen Rückrotator 8 aus. Außerdem liegt an dem zweiten Regler 7 die gemessene Phase ϕm an. Ein abhängig von den am zweiten Regler 7 anliegenden Signalen gebildetes Signal des zweiten Reglers 7 wird dem Regler 4 als Regelgröße angelegt. Das Signal des zweiten Reglers 7 wird als Regelgröße außerdem dem Rotator 5 und dem Rückrotator 8 angelegt. Der Regler 4 wird dem zweiten Regler 7 mit einer langsameren Zeitkonstante nachgeführt. Der Rückrotator 8 bestimmt ein Fehlersignal es, welches dem Kanalentzerrer 2 angelegt wird. Bei einer solchen Anordnung ist am Ausgang somit ein zweiter schnellerer Regelkreis mit einer geringeren Totzeit implementiert, welcher nur während eines langsamen Einschwingens des Hauptreglers wirksam ist und eine korrekte Einstellung des Kanalentzerrers 2 schneller ermöglicht.

Nachteilhaft an einer Lösung mit einem zusätzlichen zweiten Regler ist der zusätzliche Aufwand, welcher in der Bereitstellung zweier zusätzlicher Rotatorblöcke und eines zweiten Reglers besteht. Nachteilhaft ist außerdem, dass die eigentliche Träger-/Symboltaktregelung weiterhin langsam ist.

Die Aufgabe der Erfindung besteht darin, ein Verfahren und eine Schaltung zur Trägerregelung in einem Quadraturdemodulator vorzuschlagen, welche eine schnellere Regelung trotz einer bestehenden Totzeit in einer Verarbeitungsstrecke ermöglichen.

Diese Aufgabe wird durch das Verfahren zur Trägerregelung in einem Quadraturdemodulator mit den Merkmalen des Patentanspruchs 1 bzw. durch die Schaltung zur Trägerregelung in einem Quadraturdemodulator mit den Merkmalen des Patentanspruchs 9 gelöst. Vorteilhafte Ausgestaltungen sind Gegenstand abhängiger Ansprüche.

In einem Verfahren bzw. einer entsprechend ausgestalteten Schaltung zur Trägerregelung in einem Quadraturdemodulator wird ein komplexwertiges Eingangssignal einem Mischer zugeführt zum Mischen mit einer Mischfrequenz zu einem Mischsignal. Das Mischsignal wird einer Verarbeitungsstrecke zum Erzeugen eines verarbeiteten Signals zugeführt. Das verarbeitete und Signal wird einer Phasenmesseinrichtung zum Messen einer Phase des verarbeiteten Signals zugeführt. Die gemessene Phase wird unter anderem einer Phasenregelung zugeführt zum Regeln der Mischfrequenz, wobei eine durch eine Totzeit während zumindest der Verarbeitung in der Verarbeitungsstrecke anzunähernde Signalverzögerung entsteht. Dabei wird für die Regelung eine somit zeitverzögerte gemessene Phase verwendet. Um dies zu berücksichtigen und ein schnelleres Einschwingen der Regelung zu ermöglichen wird die Mischfrequenz zu einer Mischphase aufsummiert oder aufintegriert, wobei die Mischphase sowohl für den Mischvorgang verwendet wird als auch zur schnelleren Korrektur zur Phasenregelung rückgeführt wird. Ein durch diese Rückführung entstehender Fehler wird durch eine zeitverzögerte zweite Rückführung der Mischphase kompensiert.

Die zweite Rückführung wird dazu um eine Zeitdauer entsprechend der Totzeit zeitverzögert. In der Praxis ist die tatsächliche Totzeit jedoch oftmals nicht bekannt, weshalb die zweite Rückführung um eine Zeitdauer in insbesondere der Größenordnung der entsprechend einen Schätzwert darstellenden Totzeit zeitverzögert wird.

Die erste Rückführung der Mischphase erfolgt zur Phasenregelung um idealerweise insbesondere nur einen Takt oder gegebenenfalls auch mehrere Takte verzögert.

Der Phasenregelung wird gemäß einer einfachen Umsetzung einer derartigen Schaltung bevorzugt ein mittels einer Verzögerungsschaltung summiertes Phasensignal aus der gemessenen Phase und der rückgeführten Phase abzüglich der zeitverzögerten zweiten rückgeführten Phase zugeführt. Dabei wird der mittels einer Addieranordnung, welche auch zum Subtrahieren negativer Werte ausgelegt ist, aufsummierte und subtrahierte Phasenwert vor dem Zuführen zur Phasenregelung insbesondere von einer Sollphase abgezogen.

Die aufintegrierte Mischphase wird mit dem komplexwertigen Eingangssignal bevorzugt in einem CORDIC gemischt. Dies bewirkt auf einfache Art und Weise eine Phasendrehung des komplexwertigen Eingangssignals, bevor dieses der Verarbeitungsstrecke angelegt wird. In der Verarbeitungsstrecke selber findet üblicherweise keine oder eine beschränkte weitere Phasendrehung statt. Die Verwendung eines CORDIC oder einer entsprechenden Schaltung ermöglicht insbesondere auch das Mischen mit einer solchen aufintegrierten Mischphase, welche zusätzlich zur Regelung rückführbar ist.

Ein der Phasenregelung zugeführter Phasenwert wird vorzugsweise zusätzlich parallel einer Schaltung zur Offset-Korrektur zugeführt zum Bestimmen eines bleibenden Fehlers in der Istphase. In einem Integrator zum Aufintegrieren der Mischfrequenz wird ein entsprechender negativer Fehler aufaddierbar bzw. ggf. subtrahierbar. Dadurch wird ein Mitschleppen eines Phasenfehlers der Sollphase vermieden.

Zum Aufintegrieren wird bevorzugt ein umlaufender Integrator verwendet, der um 2π umläuft.

Eine derartige Verfahrensweise und Schaltung ermöglichen eine Totzeit-Kompensation, welche das Regelverhalten soweit beschleunigt, dass es vorzugsweise dem Verhalten eines Systems 1. Ordnung entspricht. Dies gilt insbesondere für das Ausregeln gleichförmiger konstanter Störungen, wie sie bei Trägerregelungen auftreten. Der zusätzliche Aufwand beschränkt sich dabei lediglich auf die Implementation einer Verzögerungsleitung, welche eine Verzögerung vorsieht, die im Idealfall der Signalverzögerung entspricht. Prinzipiell kann die Verzögerungsleitung aber auch die zeitverzögerte zweite Rückführung einer Mischphase mit einem Verzögerungswert vorsehen, welcher in vorzugsweise nicht zu großem Maße von der Totzeit der Verarbeitungsstrecke abweicht. Vorteilhaft ist insbesondere auch eine Unterabtastung möglich.

Gemäß erster Untersuchungen ist mit einer solchen Verfahrensweise oder Schaltung ein deutlich schnelleres Einschwingen erzielbar, welches vorzugsweise nur einen Bruchteil der ohne ein solches Verfahren erforderlichen Symboltakte benötigt. Beispielsweise kann gemäß erster synthetischer Berechnungen eine Einschwingdauer von ca. 500 Takten auf ca. 70 Takte reduziert werden.

Ein Ausführungsbeispiel wird nachfolgend anhand der Zeichnung näher erläutert. Es zeigen:
- Fig. 1: schematisch Komponenten einer Schaltung zur Trägerregelung in einem Quadraturdemodulator,
- Fig. 2: für das Verfahren und dessen Verständnis erforderliche Komponenten in detaillierterer Ausgestaltung; und
- Fig. 3: eine Schaltung zur Totzeit-Kompensation für Trägerund Symboltaktregelungen in einem digitalen Quadraturdemodulator gemäß dem Stand der Technik.

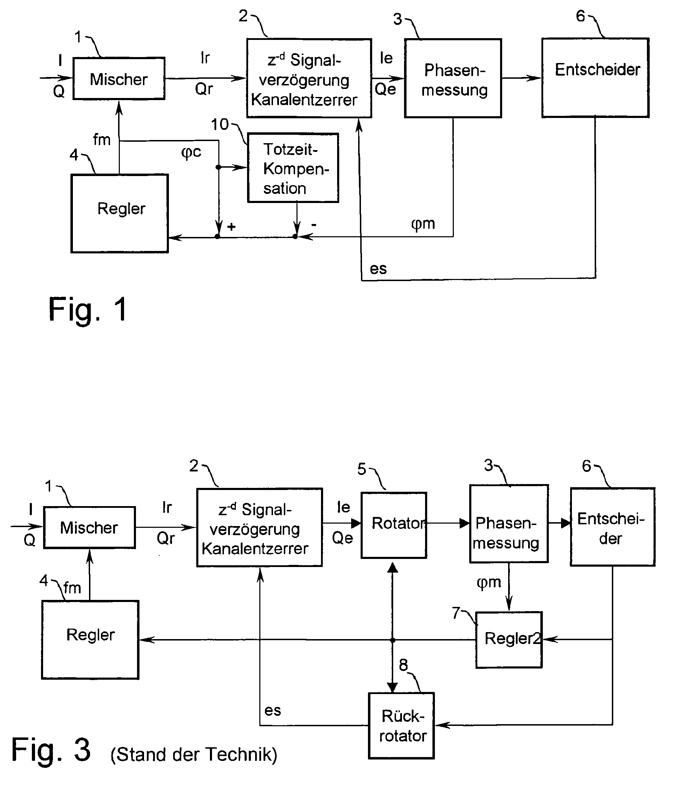

Wie dies anhand von Fig. 1 schematisch dargestellt ist, wird von dem Regler 4 die Mischfrequenz fm nicht nur dem Mischer 1 angelegt zu sondern zusätzlich die Mischfrequenz fm bzw. eine daraus gewonnene Mischphase ϕc zu einem Eingang des die Mischfrequenz fm steuernden Reglers 4 rückgeführt.

Die Rückführung der Mischphase ϕc erfolgt dabei im Rahmen einer ersten Rückführung idealerweise ohne eine zeitliche Verzögerung bzw. realistisch mit einer möglichst geringen zeitlichen Verzögerung von vorzugsweise nur einem Takt. Außerdem wird die Mischphase ϕc mittels einer zeitverzögerten zweiten Rückführung dem Regler 4 als zusätzlich zu subtrahierender Wert zugeführt. Diese zeitverzögerte zweite Rückführung mittels einer Verzögerungsschaltung 10 dient zur Totzeit-Kompensation. Die Zeitverzögerung der zeitverzögerten zweiten Rückführung entspricht idealerweise der Totzeit z^{-d} der Verarbeitungsstrecke 2, das heißt der Verarbeitungsdauer im Kanalentzerrer, bzw. versucht dieser möglichst nahe zu kommen.

Im Gegensatz zur Lösung gemäß Fig. 3 wird bei dieser Anordnung eine zweifache Rückführung der Mischphase ϕc, einmal direkt und einmal um etwa die Totzeit z^{-d} verzögert dem Regler 4, insbesondere einem Regler 4 in Form einer Phasenregelschaltung rückgeführt. Dadurch kann erstens ein zweiter Regler 7 mit zusätzlichen Rotatoren 5, 8, wie dies gemäß Fig. 3 vorgesehen ist, eingespart werden. Zweitens kann ein demgegenüber erheblich schnelleres Einschwingen des Reglers 4 bewirkt werden.

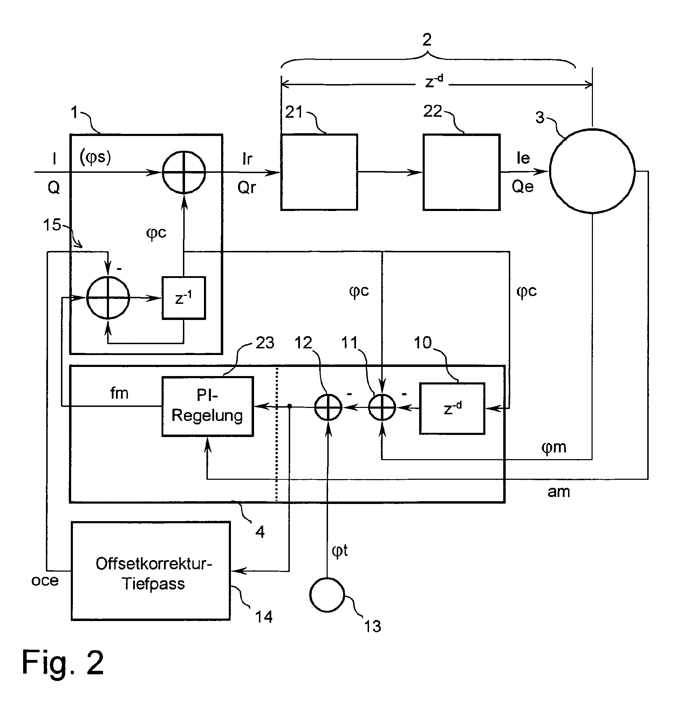

Fig. 2 zeigt Komponenten einer derartigen Schaltung mit mehr Details. Insbesondere ist in Fig. 2 gegenüber Fig. 1 zwischen den Regler 4 und die eigentliche Mischkomponente im Mischer 1 ein Integrator 15 eingesetzt, der die Mischfrequenz fm in die Mischphase ϕc umsetzt. Mit gleichen Bezugszeichen und Bezeichnungen wie bei den übrigen Figuren werden gleiche oder gleich wirkende Komponenten und Größen bezeichnet, wobei diesbezüglich auch auf Ausführungen zu den übrigen Zeichnungen verwiesen wird.

An dem Mischer 1 wird wieder ein komplexwertiges Eingangsignal I, Q angelegt, welchem eine Signalphase ϕs zugrunde liegt. Dieses Eingangssignal I, Q wird einem CORDIC angelegt, welcher als ein Addierer 20 skizziert ist. Der CORDIC führt eine Koordinations-Rotation des angelegten komplexwertigen Eingangssignals auf Basis der zusätzlich am CORDIC anliegenden Mischphase ϕc durch. Ausgegeben wird von dem Mischer 1 entsprechend ein rotiertes komplexwertiges Mischsignal Ir, Qr, welches sich mathematisch beschreiben lässt gemäß Ir + jQr = (I + jQ)e^{iϕ}.

Dieses Mischsignal Ir, Qr wird der Verarbeitungsstrecke 2 zugeführt, welche beispielsweise als eine Schaltung zum Herausfiltern von Intersymbolfrequenzen mittels eines Nyquistfilters 21 ausgebildet ist. Dessen Ausgangsergebnis wird anschließend beispielsweise einem Equalizer 22 angelegt, welcher Signalverzögerungen entfernt. Das Ausgangsergebnis des Equalizers 22 stellt das Ende der eigentlichen Verarbeitungsstrecke 2 dar. Entsprechend gibt der Equalizer 22 ein komplexwertiges verarbeitetes Signal Ie, Qe aus, welches einer Schaltung zur Phasenmessung 3 angelegt wird. Die Schaltung zur Phasenmessung 3 kann vorzugsweise durch einen CORDIC ausgebildet werden.

Die Strecke vom Ausgang des Mischers 1 bis einschließlich zur Schaltung zur Phasenmessung 3 bewirkt eine Zeitverzögerung, welche einer Totzeit z^{-d} mit einer Zeitverzögerung von d Takten entspricht.

Die Schaltung zur Phasenmessung 3 führt eine Umwandlung von kartesischen Koordinaten zu polaren Koordinaten durch und gibt einen Phasenwert als eine gemessene Phase ϕm sowie einen Amplitudenwert am zu dem verarbeiteten komplexwertigen Signal Ie, Qe aus. Diese Ausgangswerte können, wie in Fig. 1 dargestellt, beispielsweise einem Entscheider zur weiteren Verarbeitung zugeführt werden.

Für die Träger- und Symboltaktregelung in einem Quadraturdemodulator werden die von der Schaltung zur Phasenmessung 3 ausgegebenen Werte einem Regler 4 zur Phasenregelung mit einer Phasenregelungsschaltung 23 angelegt. Einem Phaseneingang der Phasenregelungsschaltung 23 liegt außerdem eine Sollphase ϕt von einer Phasen- bzw. Taktquelle 13 an. Der Sollphase ϕt wird vor dem Zuführen zur Phasenregelungsschaltung der Wert der von der Schaltung zur Phasenregelung 3 gelieferten gemessenen Phase ϕm in einem Addierer 12 bzw. Subtrahierer abgezogen. Zuvor bzw. zusätzlich wird der gemessenen Phase ϕm in demselben Addierer oder in einem weiteren, insbesondere vorgeschalteten Addierer 11 die aktuelle Mischphase ϕc addiert, welche parallel dem CORDIC 20 in dem Mischer 1 angelegt wird. Diese Mischphase ϕc wird somit zu dem Eingang der Phasenregelungsschaltung 23 direkt rückgeführt. Unter einer direkten Rückführung ist dabei insbesondere eine um einen Takt verzögerte Rückführung zu verstehen, wobei, sofern technisch erforderlich, gegebenenfalls auch noch mehr Takte Verzögerung vorgesehen werden können.

Die Mischphase ϕc wird außerdem im Rahmen einer zeitverzögerten zweiten Rückführung zusätzlich einer Verarbeitungsstrecke als einer Schaltung zur Totzeit-Kompensation 10 zugeführt. Die Verarbeitungsstrecke 2 bewirkt eine Verzögerung der aufeinander folgend angelegten Werte der Mischphase ϕc um eine Anzahl von Takten, wie sie der Gesamt-Verarbeitungsstrecke bzw. Totzeit z^{-d} der Verarbeitungsstrecke 2 entspricht. Eine Abweichung von diesem Wert ist für die Schaltung tolerierbar und führt idealerweise lediglich zu einem etwas verzögerten Einschwingen. Eine Abweichung von der Totzeit z^{-d} ergibt sich insbesondere auch dadurch, dass die Totzeit z^{-d} der Schaltungskomponenten durch den adaptiven Equalizer 22 variieren kann und eine Totzeit z^{-d} das Verhalten der Regelstrecke modellhaft vereinfacht. Der jeweils um die Anzahl d der zeitverzögerten zweiten Mischphasen ϕc verzögert ausgegebene Wert wird von der Phase abgezogen, insbesondere in dem zweiten Addierer 11 abgezogen, welche an der Phasenregelungsschaltung 23 angelegt wird. Dies bewirkt, dass ein anfänglich zur schnelleren Erzielung des Einschwingens aufintegrierte Mischphasenwert nach der Totzeit z^{-d} wieder abgezogen wird.

Mit anderen Worten, wird die Mischphase ϕc auf den Eingang des Phasenreglers bzw. der Phasenregelungsschaltung 23 rückgeführt und somit die Regelung mit einem geschätzten Wert, das heißt einem eigentlich falschen Wert, kurzgeschlossen. Zusätzlich wird der Mischphasenwert um die Totzeit z^{-d} verzögert, um diesen in der Regelung eigentlich falschen Wert wieder abzuziehen, wenn der Wert der wirklichen gemessenen Phase ϕm am Eingang des Regelkreises, das heißt am Eingang der Phasenregelungsschaltung 23, ankommt.

Vom Ausgang der Phasenregelungsschaltung 23 wird die Mischfrequenz fm ausgegeben und einem Integrator 15 angelegt. Der Integrator 15 besteht vorzugsweise aus einem Addierer und einem Register- bzw. Verzögerungsglied z⁻¹ , welche als Schleife geschaltet sind. Ein Wert des Verzögerungsglieds z⁻¹ wird bei jedem Takt sowohl einem Additionseingang des Addierers angelegt als auch als die Mischphase ϕc ausgegeben. In dem Verzögerungsglied z⁻¹ sammelt sich die im Integrator 15 aufaddierte Summe. Bei dem Integrator 15 handelt es sich um einen im Zweierkomplement umlaufenden Integrator, dessen Werte Phasenwinkeln als Mischphase ϕc zugeordnet sind, die mit 2π umlaufen.

Von dem Integrator 15 bzw. von dessen Verzögerungsglied z⁻¹ ausgehend wird die Mischphase ϕc dem vorzugsweise als CORDIC ausgebildeten Mischer 1 angelegt. Dabei handelt es sich um einen CORDIC, der das komplexwertige Eingangssignal I, Q um den Wert der Mischphase ϕc dreht und den gedrehten Wert wieder ausgibt, wodurch effektiv eine Mischung mit der Mischfrequenz durchgeführt wird.

Eine solche Schaltung wäre bei exakter Kenntnis der tatsächlichen Anzahl d von Takten der Totzeit z^{-d} ideal zur Korrektur. Tatsächlich handelt es sich jedoch bei dem Verzögerungswert nur um eine geschätzte Anzahl d von Takten, welche nicht zwingend mit der tatsächlichen Anzahl von Takten einer Verzögerung in der Verarbeitungsstrecke 2 übereinstimmt. Problematisch ist dies, wenn in der Schaltungsanordnung ein Entscheider angeordnet ist, welcher eine exakte Nullphase benötigt. Um einen Nullphasenfehler zu korrigieren, wird der Phasenwert am Eingang der Phasenregelschaltung abgegriffen und einer Schaltung zur Offset-Korrektur 14, insbesondere einem Offset-Korrektur-Tiefpass-Filter zugeführt. Ein von dieser Schaltung zur Offset-Korrektur 14 bestimmter Fehlerwert oce wird dann in dem Integrator 15 vom aufzuintegrierenden Wert subtrahiert.

Eine solche Verfahrensweise berücksichtigt, dass die reale Totzeit oftmals nicht der kompensierten Zeit entspricht, so dass beim Abziehen der verzögerten zweiten Mischphase ϕc kein richtiger zutreffender Wert genommen wird. Dies hat zur Folge, dass die verzögerte Mischphase ϕc in der Regel immer zu früh oder immer zu spät abgezogen wird. Im Integrator 15 bewirkt dies, dass ein negativer Fehler aufintegriert wird, was zu einem bleibenden Fehler der Ist-Phase führt. Dieser Fehlerwert wird mittels der Schaltung zur Offset-Korrektur 14 gemessen und im Integrator 15 wieder abgezogen. Dadurch wird einer bleibenden Phasenabweichung im Regelkreis entgegengewirkt, so dass für in der Schaltungsanordnung befindlicher Entscheider eine vorzugsweise ideale Nullphase geboten wird.

## Patentansprüche

1. Verfahren zur Trägerregelung in einem Quadraturdemodulator, bei dem
- ein komplexwertiges Eingangssignal (I, Q) einem Mischer (1) zugeführt wird zum Mischen mit einer Mischfrequenz (fm) zu einem Mischsignal (Ir, Qr),
- das Mischsignal (Ir, Qr) einer Verarbeitungsstrecke (2) zum Erzeugen eines verarbeiteten Signals (Ie, Qe) zugeführt wird,
- das verarbeitete Signal (Ie, Qe) einer Phasenmesseinrichtung (3) zum Messen einer Phase (ϕm) des verarbeiteten Signals (Ie, Qe) zugeführt wird und
- die gemessene Phase (ϕm) einer Phasenregelung (4) zugeführt wird zum Regeln der Mischfrequenz (fm),
- wobei während zumindest der Verarbeitung in der Verarbeitungsstrecke (2) eine durch eine Totzeit (z^{-d}) anzunähernde Signalverzögerung entsteht,
**dadurch gekennzeichnet, dass**
- die Mischfrequenz (fm) aufsummiert oder aufintegriert wird zu einer Mischphase (ϕc),
- die Mischphase (ϕc) sowohl für den Mischvorgang verwendet wird als auch zur Phasenregelung (4, 23) rückgeführt wird und
- ein durch die Rückführung entstehender Fehler durch eine zeitverzögerte zweite Rückführung der Mischphase (ϕc) kompensiert wird.

2. Verfahren nach Anspruch 1, bei dem die zweite Rückführung um eine Zeitdauer in der Größenordnung der Totzeit (z^{-d}) zeitverzögert wird.

3. Verfahren nach Anspruch 1 oder 2, bei dem die erste Rückführung der Mischphase (ϕc) zur Phasenregelung um nur mindestens einen Takt verzögert zur Phasenregelung (4) rückgeführt wird.

4. Verfahren nach einem vorstehenden Anspruch, bei dem der Phasenregelung (4) ein summiertes Phasensignal aus der gemessenen Phase (fm) und der rückgeführten Phase (ϕc) abzüglich der zeitverzögerten zweiten rückgeführten Phase (ϕc(z^{-d})) zugeführt wird.

5. Verfahren nach Anspruch 4, bei dem der aufsummierte und subtrahierte Phasenwert vor dem Zuführen zur Phasenregelung (4) von einer Sollphase (ϕt) abgezogen wird.

6. Verfahren nach einem vorstehenden Anspruch, bei dem die aufintegrierte Mischphase (ϕc) in einem CORDIC mit dem komplexwertigen Eingangssignal (I, Q) gemischt wird.

7. Verfahren nach einem vorstehenden Anspruch, bei dem ein der Phasenregelung (4) zugeführter Phasenwert parallel einer Offset-Korrektur (14) zugeführt wird zum Bestimmen eines bleibenden Fehlers in der Istphase, wobei einem Integrator zum Aufintegrieren der Mischfrequenz (fm) ein entsprechender negativer Fehler (oce) aufaddiert wird.

8. Verfahren nach einem vorstehenden Anspruch, bei dem zum Aufintegrieren ein umlaufender Integrator (15) verwendet wird.

9. Schaltung zur Trägerregelung in einem Quadraturdemodulator, bei der
- ein Mischer (1) ein komplexwertiges Eingangssignal (I, Q) mit einer Mischfrequenz (fm) zu einem Mischsignal (Ir, Qr) mischt,
- eine Verarbeitungsstrecke (2) das Mischsignal (Ir, Qr) zu einem verarbeiteten Signal (Ie, Qe) verarbeitet,
- eine Phasenmesseinrichtung (3) zu dem verarbeiteten Signal eine Phase (ϕm) misst und
- eine Phasenregelung (4) mittels der gemessenen Phase (ϕm) die Mischfrequenz (fm) regelt,
- wobei durch zumindest die Verarbeitung in der Verarbeitungsstrecke (2) eine Totzeit (z^{-d}) entsteht,
**dadurch gekennzeichnet, dass**
- die Schaltung (15) ausgebildet und/oder angesteuert ist, die Mischfrequenz (fm) aufzusummieren oder aufzuintegrieren zu einer Mischphase (ϕc), und
- die Mischphase (ϕc) sowohl für den Mischvorgang im Mischer zu verwenden als auch zur Phasenregelung (4, 23) rückzuführen und
- einen durch die Rückführung entstehenden Fehler durch eine zeitverzögerte zweite Rückführung der Mischphase (ϕc) zu kompensieren.

10. Schaltung nach Anspruch 9 mit einer Verzögerungsschaltung (10) zum Zeitverzögern der Mischphase (ϕc) für die zweite Rückführung um eine Zeitdauer in der Größenordnung der Totzeit (z^{-d}).

11. Schaltung nach Anspruch 9 oder 10, bei der die Mischphase (ϕc) für die erste Rückführung um insbesondere nur einen Takt verzögert direkt zur Phasenregelung (4) geschaltet ist.

12. Schaltung nach einem vorstehenden Anspruch mit zumindest einem Addierer (11), welcher der Phasenregelung (4) ein summiertes Phasensignal aus der gemessenen Phase (fm) und der rückgeführten Phase (ϕc) abzüglich der zeitverzögerten zweiten rückgeführten Phase (ϕc(z^{-d})) zuführt.

13. Schaltung nach Anspruch 12 mit einem Addierer (12) zum Abziehen des aufsummierten und subtrahierten Phasenwertes vor dem Zuführen zur Phasenregelung (4) von einer Sollphase (ϕt).

14. Schaltung nach einem vorstehenden Anspruch mit einem CORDIC zum Mischen des komplexwertigen Eingangssignals (I, Q) mit der aufintegrierten Mischphase (ϕc).

15. Schaltung nach einem vorstehenden Anspruch mit
- einer Schaltung zur Offset-Korrektur (14), der ein der Phasenregelung (4) zugeführter Phasenwert zugeführt wird zum Bestimmen eines bleibenden Fehlers (oce) in der Istphase, und
- einem Integrator (15) zum Aufintegrieren der Mischfrequenz (fm) und zum Aufaddieren eines entsprechenden negativen Fehlers (oce).

16. Schaltung nach einem vorstehenden Anspruch mit einem Integrator (15) zum Aufintegrieren, wobei der Integrator (15) als ein umlaufender Integrator (15) ausgestaltet oder angesteuert ist.
